(19)

Europäisches
Patentamt
European
Patent Office
Office européen
des brevets

(11) **EP 3 496 277 A1**

(12) **EUROPEAN PATENT APPLICATION**

(43) Date of publication:
**12.06.2019 Bulletin 2019/24**

(51) Int Cl.:
**H03M 13/11** *(2006.01)*

(21) Application number: **17205983.4**

(22) Date of filing: **07.12.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD TN**

(71) Applicant: **Xieon Networks S.à r.l.
2633 Senningerberg (LU)**

(72) Inventors:
• **Calabrò, Stefano**
  2633 Senningerberg (LU)
• **Kainzmaier, Peter**
  2633 Senningerberg (LU)
• **von Kirchbauer, Heinrich**
  2633 Senningerberg (LU)

(74) Representative: **Kretschmann, Dennis
Boehmert & Boehmert
Anwaltspartnerschaft mbB
Pettenkoferstrasse 22
80336 München (DE)**

(54) **PARALLEL ENCODING METHOD AND SYSTEM FOR PROTOGRAPH-BASED LDPC CODES WITH HIERARCHICAL LIFTING STAGES**

(57)    Method and system for parallel, systematic encoding of a quasi-cyclic LDPC code constructed by applying iterative, hierarchical lifting and having a parity check matrix with a triangular sub-matrix. The encoding method and encoding architecture is suitable for high-speed low-power VLSI implementation and characterized by a degree of parallelism equal to the product of the upper lifting factors and a hybrid implementation of a bit permutation, whereby the functionality of the lower lifting stages is realized in RAM and that of the upper lifting stages is realized in combinatorial logic.

Fig. 3

## Description

Technical Field

The invention relates to the field of encoding for parity-checlc codes, in particular high-speed encoding for low-density parity check (LDPC) codes.

Background and State of the Art

Linear codes over a finite field can be defined as the null space (or kernel) of a parity-check matrix (PCM) $H$ or, equivalently, as the span of a generator matrix G.

Low-density parity-check (LDPC) codes are linear codes defined by sparse PCMs and are known for their excellent error correction capability. LDPC decoding usually relies upon belief propagation over the bipartite graph associated with the PCM and, due to the sparseness of $H$, has linear complexity in the word length.

In the following, it will be useful to refer to the two sub-matrices $H_1$ and $H_2$ of the PCM, defined by the relation

$$H = [H_1 \quad H_2], \qquad\qquad (1)$$

where $H_1$ and $H_2$ have size $(n - k) \times k$ and $(n - k) \times (n - k)$, respectively. The positive integer n denotes a block length of a code word, and the positive integer $k$ denotes a block length of an input information word.

A natural encoding algorithm of linear codes, and therefore also of LDPC codes, relies on their representation via the generator matrix $G$: a code word of size $n$ is obtained by multiplying an input information row-vector of size $k$ by the generator matrix of size $k \times n$. Unfortunately, a sparse PCM $H$ does not imply a sparse generator matrix $G$ and, therefore, for a generic, randomly constructed LDPC code, encoding, in contrast to belief propagation decoding, has quadratic complexity in the code word length. In practice, encoding represents a major hurdle to the implementation of generic random LDPC codes.

T. J. Richardson and R. L. Urbanke in their paper "Efficient encoding of low-density parity-check codes," published in 2001 in the IEEE Transactions on Information Theory, vol. 47, no. 2, pages 638-656, propose to bring the submatrix $H_2$ into an approximate lower triangular form by performing row and column permutations only of the PCM, which do not alter its sparseness. The resulting encoding complexity is linear except for a quadratic term with a small coefficient. A disadvantage of this method is that column permutations lead to non-systematic encoding. Additionally, the resulting hardware architectures are not completely regular and do not scale favorably at high throughput rates.

A different research trend considers encoding algorithms based on the LU factorization of the sub-matrix $H_2$ or its inverse transpose $(H_2^T)^{-1}$. In particular, A. Mahdi and V. Paliouras in the paper "A low complexity-high throughput QC-LDPC encoder", published in the IEEE Transactions on Signal Processing, vol. 62, no. 10, pages 2696-2708, 2014, propose the use of recursively-constructed quasi-cyclic (QC) LDPC codes to achieve low-encoding complexity.

In view of the prior art, what is needed is an encoding method and system that reduces the encoding complexity and allows for an efficient hardware architecture, in particular a hardware architecture that reduces the number of read and write accesses to memory.

Overview of the Invention

This objective is addressed with an encoding method according to independent claim 1, and an encoding system according to independent claim 11. The dependent claims relate to preferred embodiments.

In a first aspect, the invention relates to an encoding method for a parity-check code, wherein the encoding is based on a parity check matrix that comprises at least two sub-matrices, wherein at least one of the sub-matrices is a triangular matrix. The parity check matrix H is a $(n - k) \times n$ matrix, wherein $n$ denotes a block length of a code word and $k$ denotes a block length of an input word, and wherein the parity check matrix H can be represented in the form

$$H = [H_1 \quad H_2], \qquad\qquad (2)$$

wherein $H_1$ is a $(n-k) \times k$ matrix, and $H_2$ is a triangular $(n-k) \times (n-k)$ matrix.

The method comprises generating the parity check matrix by means of iterative lifting of smaller parity check matrices.

A parity check matrix with a triangular sub-matrix allows for a particularly efficient encoding, with a coding complexity that scales linearly in the length of the information blocks to be encoded. Moreover, the structure of the parity check matrix allows for an efficient implementation that minimizes the read and write accesses to memory of the encoding circuit.

A triangular matrix, in the sense of the present disclosure, may be a matrix in which all the matrix entries above the diagonal entries, or below the diagonal entries are "o" entries.

The triangular matrix may be a matrix having an equal number of rows and columns, wherein the number of rows and columns may be any integer value $\geq 2$.

Iterative lifting allows to preserve the triangular structure of the sequence of parity check matrices, and hence allows for a particularly efficient iterative code generation.

According to an embodiment, iterative lifting comprises: providing a first parity check matrix, wherein the first parity check matrix comprises a first sub-matrix that is triangular; and generating a second parity check matrix from the first parity check matrix, wherein the second parity check matrix is larger than the first parity check matrix and is obtained from the first parity check matrix by replacing zero entries of the first parity check matrix with zero matrices, and replacing non-zero entries of the first parity check matrix with permutation matrices.

A permutation matrix, in the sense of the present disclosure, may be a matrix with exactly one "1" entry in each row and column, and "o" entries elsewhere.

In particular, some or all of the permutation matrices maybe circulant matrices.

A circulant matrix, in the sense of the present disclosure, may be a permutation matrix in which each row vector or each column vector is cyclically rotated by one element relative to the preceding row vector or column vector, respectively.

In the iterative lifting, non-zero diagonal entries of the first sub-matrix may be replaced by identity matrices, so to obtain a second triangular sub-matrix.

The encoding method may further comprise: generating a third parity check matrix from the second parity check matrix, wherein the third parity check matrix is larger than the second parity check matrix and is obtained from the second parity check matrix by replacing zero entries of the second parity check matrix with zero matrices, and replacing non-zero entries of the second parity check matrix with permutation matrices, in particular circulant matrices.

Non-zero diagonal entries of the second sub-matrix may be replaced by identity matrices.

This lifting process may be repeated for the forth and any further parity check matrix. In this way, the final parity check matrix for the parity check code may be efficiently generated iteratively from smaller parity check matrices.

In the context of the present disclosure, the number of rows, or number of columns of the permutation matrix, or circulant matrix employed in the lifting may be called a lifting factor.

According to an embodiment, the encoding has a degree of parallelism that corresponds to a product of a plurality of lifting factors, in particular a product of a subset of the lifting factors.

The subset of the lifting factors may comprise all the lifting factors including and beyond the m-th lifting factor, for any integer $m \geq 2$.

According to an embodiment, the parity-check code is a systematic code.

A systematic code, in the sense of the present disclosure, may denote a code in which the information symbols are embedded in the code words.

According to an embodiment, the encoding comprises a parallel processing of a plurality of rows of the parity check matrix, in particular a parallel processing of all rows of the parity check matrix. In particular, the encoding may comprise a parallel processing in a plurality of encoding paths, wherein each encoding path pertains to a row of the parity check matrix.

According to an embodiment, the encoding comprises permuting a plurality of input symbols.

The encoding method according to the present disclosure may be implemented in an encoding circuit, which may be a circuit comprising hardware elements and/or software elements. In particular, the encoding circuit may comprise a combinational logic circuit or switching logic circuit. In some embodiments, the encoding circuit may comprise a memory element, such as a RAM element.

The encoding may comprise applying a first plurality of permutations to an input symbol, the first plurality of permutations pertaining to a first plurality of lifting stages, in particular a first plurality of lifting stages consisting of all lifting stages including and beyond the m-th lifting stage, for an integer $m \geq 2$.

According to an embodiment, the first plurality of permutations are applied by means of a combinational logic circuit, or a switching logic circuit.

In an example, the permuting is realized by means of barrel shifters.

The encoding may comprises an accumulated addition operation, in particular after a step of permuting a plurality of input symbols.

In an example, the accumulated addition operation comprises a second plurality of permutations pertaining to a second plurality of lifting stages, in particular a second plurality of lifting stages consisting of all lifting stages below the m-th lifting stage, for an integer m ≥ 2.

According to an embodiment, the second plurality of lifting stages may be applied by means of a memory element, in particular a RAM element.

The accumulated addition operation may employ a memory with a single read port and a single write port.

Hence, according to an example, the method comprises a hybrid permutation of the input symbols. In particular, the second plurality of permutations corresponding to the lifting stages 1 to m-1, for an integer m ≥ 2, may be implemented by means of the memory element, in particular the RAM element. The first plurality of permutations corresponding to the upper lifting stages including and beyond the m-th lifting stage may be implemented in combinational logic, or switching logic.

The value m ≥ 2 is smaller than the total number of lifting stages, and can be a predetermined parameter selected depending on the chip performance.

This allows for a particularly efficient and fast encoding, with minimal resources.

According to an embodiment, the encoding comprises computing a second plurality of parity check symbols pertaining to a second input block as an accumulated addition operation of a plurality of information symbols pertaining to the second input block and a first plurality of parity check symbols pertaining to a first input block, wherein the first input block in particular precedes the second input block.

In an example, the encoding comprises backfeeding parity check symbols from an output of an encoding circuit to an input of the encoding circuit.

Hence, the encoding circuit according to the present disclosure may generate parity check symbols iteratively based on the parity check symbols obtained for a previous block. This simplifies the encoder architecture, and leads to a particularly efficient coding scheme.

In a second aspect, the disclosure relates to an encoding system, implementing an encoding based on a parity check matrix that comprises at least two sub-matrices, wherein at least one of the sub-matrices is a triangular matrix. The parity check matrix is a (n-k) x n parity check matrix, wherein n denotes a block length of a code word and k denotes a block length of an input word, wherein the parity check matrix can be represented in the form of equation (2), and the encoding system is adapted to generate the parity check matrix by means of iterative lifting of smaller parity check matrices.

The parity check matrix may be a parity check matrix with some or all of the features described above.

The system may comprise an encoding circuit.

According to an embodiment, the encoding system comprises a first plurality of permutator elements adapted to apply a first plurality of permutations to an input symbol, the first plurality of permutations pertaining to a first plurality of lifting stages.

In particular, the first plurality of lifting stages may consist of all lifting stages including and beyond the m-th lifting stage, for an integer m ≥ 2.

According to an example, the first plurality of permutator elements may comprise a combinational logic circuit, or switching logic circuit.

According to an embodiment, the encoding system may comprise a plurality of accumulator elements adapted to perform an accumulated addition operation.

In particular, the plurality of accumulator elements may be located downstream of the first plurality of permutator elements.

According to an example, the plurality of accumulator elements comprises a respective second plurality of permutator elements.

In an example, the second plurality of permutator elements may be adapted to apply a second plurality of permutations pertaining to a second plurality of lifting stages, in particular a second plurality of lifting stages consisting of all lifting stages below the m-th lifting stage, for an integer m ≥ 2

The second plurality of permutator elements may comprise memory elements, in particular RAM elements.

Hence, the encoding system may be adapted to employ the permutation in a hybrid implementation, wherein the functionality of the lower lifting stages is realized in RAM, and the functionality of the upper lifting stages is realized in combinational logic.

According to an embodiment, the encoding system is adapted to compute parity symbols, and backfeed the computed parity symbols to an input of the encoding system.

The backfeeding of parity symbols constitutes an independent aspect of the present disclosure.

In particular, according to a third aspect the invention relates to an encoding system, comprising: an input node for receiving information symbols; and an encoding circuit connected to the input node. The encoding circuit comprises a plurality of permutator elements associated with a plurality of encoding paths; and a plurality of accumulator elements associated with the plurality of encoding paths. The encoding circuit further comprises a feedback path adapted to backfeed output symbols of the encoding circuit to an input of the encoding circuit; and an output node connected to the encoding circuit, wherein the output node is adapted to output codeword symbols.

The encoding system may be adapted to implement the encoding method with some or all of the features described above.

According to an embodiment, the plurality of accumulator elements are located downstream from the plurality of permutator elements in the plurality of encoding paths.

In an example, the encoding circuit comprises a row selector element, in particular downstream from the plurality of accumulator elements.

The encoding circuit may be adapted to compute parity symbols.

According to an embodiment that may implement a systematic encoder, the encoding system further comprises a bypass path adapted to provide the information symbols from the input node to the output node.

The encoding system may be adapted to alternatively connect the input node and the feedback path to the input of the encoding circuit, in particular by means of a switch.

According to an embodiment, the permutator elements are adapted to apply a first plurality of permutations pertaining to a first plurality of lifting stages, in particular a first plurality of lifting stages including and beyond the m-th lifting stage, for an integer $m \geq 2$.

The permutator elements may comprise a combinational logic circuit, or switching logic circuit.

In an example, the permutator elements comprise barrel shifters.

According to an embodiment, the plurality of accumulator elements are adapted to apply a second plurality of permutations pertaining to a second plurality of lifting stages, in particular a second plurality of lifting stages below the m-th lifting stage, for an integer $m \geq 2$.

According to an embodiment, the plurality of accumulator elements may comprise a second plurality of permutator elements adapted to implement a second plurality of permutations pertaining to a second plurality of lifting stages.

In particular, the second plurality of lifting stages may consist of all lifting stages below the m-th lifting stage, for $m \geq 2$.

According to an embodiment, the plurality of accumulator elements are adapted to compute a second plurality of parity symbols pertaining to a second input block of information symbols as an accumulated addition operation of a plurality of information symbols pertaining to the second input block provided from the input note, and a first plurality of parity symbols pertaining to a first input block of information symbols, wherein the first plurality of parity symbols are provided via the feedback path.

Each of the plurality of accumulator elements, or each of the second plurality of permutator elements may comprise a memory element, in particular a RAM element.

Each of the plurality of accumulator elements may comprise a memory with a single read port and a single write port.

Brief Description of the Drawings

The features of the present invention and the numerous advantages associated therewith will be best apparent from a detailed description of example embodiments with reference to the accompanying drawings, in which:

Fig. 1    is a schematic diagram illustrating a data transmission process that employs an encoding method and system according to an embodiment;

Fig. 2    is a schematic illustration of a lifting procedure that may be employed in an encoding method according to an embodiment;

Fig. 3    is a schematic diagram illustrating an encoder architecture of an encoding system according to an embodiment;

Fig. 4    is a schematic diagram illustrating a permutator element that may be used in an encoding system according to an embodiment;

Fig. 5    is a schematic block diagram of a barrel shifter that that may be used in an encoding system according to an embodiment; and

Fig. 6    is a schematic diagram illustrating an accumulator element that may be used in an encoding system according to an embodiment.

Description of Embodiments

In this disclosure, we consider a special class of low density parity check (LDPC) codes that admit linear-complexity encoding, and we describe an efficient hardware architecture for the implementation of suitable high-speed encoders. The encoding method and encoding system may be employed for the transmission of digital information over optical networks. However, this is merely an example, and in general the encoding techniques according to the present disclosure may be employed for any kind of data storage, data compression, or data transmission over any possible transmission medium.

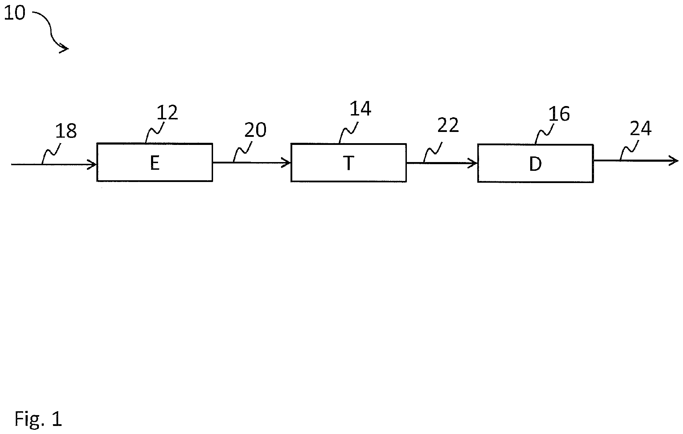

Fig. 1 is a schematic illustration of a data transmission system 10 that employs an encoding method and system according to an embodiment.

The data transmission system 10 comprises an encoding system 12, a transmission channel 14, and a decoding system 16. The encoding system 12 receives input symbols 18, such as a string of digital data bits, and encodes them by means of an encoding method that generates a string of code symbols 20. These code symbols 20 are subjected to the transmission channel 14, which models transmission of the code symbols 20 over a transmission path, such as an optical fibre channel, from a sender station to a receiver station. The transmitted code symbols 22 received at the receiver station maybe subjected to the decoding system 16, which converts them into decoded code symbols 24. Ideally, the decoded code symbols 24 are identical to the input symbols 18, or at least a very close approximation.

In general, the input information may be represented by any kind of symbols, such as any b-ary symbols. However, in the following examples we focus on binary symbols, for the ease of presentation.

We consider a special class of LDPC codes for the encoding system 12 that

- have a parity check matrix H with triangular sub-matrix $H_2$ according to Eq. (2), and
- are constructed by applying hierarchical lifting to a protograph.

For this class of codes we describe an encoder architecture suitable for a high-speed low-power very large scale integration (VLSI) implementation, and characterized by

- a degree of parallelism equal to the product of the upper lifting factors, and
- a hybrid implementation of a bit permutation, whereby the functionality of the lower stages is realized in RAM and that of the upper stages is realized in combinational logic (also denoted by switching logic).

In contrast to some state-of-the-art solutions that, like ours, exploit structural properties of the PCM, we require the sub-matrix $H_2$ to be triangular rather than approximately triangular or dual diagonal. Also, differently from other solutions applicable to quasi-cyclic LDPC codes we do not make use of a LU decomposition. An advantage of our solution lies in the efficient implementation of the bit permutation, which exploits the construction by means of hierarchical lifting to enable high throughput without incurring routing congestion.

By using a protograph approach, we design LDPC code ensembles with triangular $H_2$ and excellent performance. The possibility of using a PCM with a triangular sub-matrix $H_2$ without suffering from performance penalties leads to significant simplifications in the encoding algorithm.

***Code Construction***

Let us denote by $H^{(0)}$ the protomatrix associated with the considered protograph, and let us introduce the sub-matrices $H_1^{(0)}$ and $H_2^{(0)}$ of size $(n^{(0)} - k^{(0)}) \times k^{(0)}$ and $(n^{(0)} - k^{(0)}) \times (n^{(0)} - k^{(0)})$, respectively, such that

$$H^{(0)} = \begin{bmatrix} H_1^{(0)} & H_2^{(0)} \end{bmatrix}. \qquad (3)$$

We pose the following constraints on the structure of $H_2^{(0)}$:

- The diagonal elements have value 1;
- The elements above the diagonal are zero, i.e., the matrix is lower triangular. Alternatively, an upper triangular matrix could be used.

The protomatrix $H^{(0)}$ or, equivalently, the protograph can be designed according to customary techniques, as e.g. density evolution.

Subsequently, we apply $l$ hierarchical lifting stages to the protograph with a similar procedure to that described by N. Miladinovic and M. Fossorier in "Systematic recursive construction of LDPC codes," IEEE Communications Letters, vol. 8, no. 5, 2004, pages 302-304. At stage $i(i = 0, 1, ..., l\text{-}1)$ we use cyclic permutation matrices and zero-matrices of size $q^{(i)} \times q^{(i)}$ to lift the protomatrix $H^{(0)}$ and obtain the new protomatrix

$$H^{(i+1)} = \begin{bmatrix} H_1^{(i+1)} & H_2^{(i+1)} \end{bmatrix}, \tag{4}$$

where $H_1^{(i+1)}$ and $H_2^{(i+1)}$ have size $(n^{(i+1)} - k^{(i+1)}) \times k^{(i+1)}$ and $(n^{(i+1)} - k^{(i+1)}) \times (n^{(i+1)} - k^{(i+1)})$, respectively, with

$$k^{(i+1)} = k^{(0)} \prod_{j=0}^{i} q^{(j)} \tag{5}$$

and

$$n^{(i+1)} = n^{(0)} \prod_{j=0}^{i} q^{(j)}. \tag{6}$$

The protomatrix obtained after the last lifting stage coincides with the desired PCM

$$H = \begin{bmatrix} H_1 & H_2 \end{bmatrix} \triangleq H^{(l)} = \begin{bmatrix} H_1^{(l)} & H_2^{(l)} \end{bmatrix}. \tag{7}$$

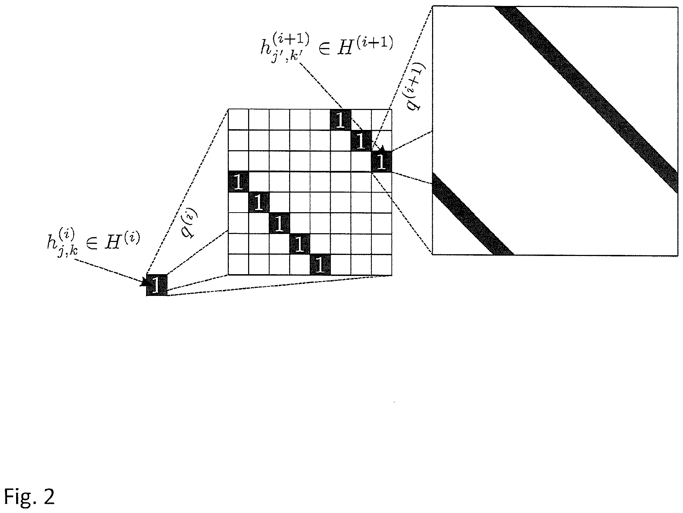

Fig. 2 provides a graphical exemplification of the lifting procedure at two successive stages. At the lifting stage $i$ an entry $h_{j,k}^{(i)} = 1$ of the protomatrix $H^{(i)}$ is replaced by a $q^{(i)} \times q^{(i)}$ circulant matrix. Subsequently, at the lifting stage $i + 1$, a resulting entry $h_{j',k'}^{(i+1)} = 1$ is replaced in turn by a $q^{(i+1)} \times q^{(i+1)}$ circulant matrix.

At the lifting stage $o$ each entry equal to any integer $v > 1$ is replaced by the sum of $v$ different circulant matrices of size $q^{(0)} \times q^{(0)}$. With the first lifting stage we take care of removing all multiple edges from the protograph, i.e., all entries with value larger than one from the protomatrix. To this end, $q^{(0)}$ may be equal to or larger than the maximum entry of $H^{(0)}$. If the initial protograph has no parallel edges, this initial step may be skipped, i.e. $q^{(0)}$ may be set to one.

We may constrain the lifting procedure described above by adopting at the $i$-th stage $(i = 0,1, ..., l\text{-}1)$ zero-shift permutation matrices (i.e. identity matrices) for the diagonal elements of $H_2^{(i)}$. This condition simplifies encoding without affecting the code performance.

The product of the lifting factors employed at the lifting stages 1, 2, ..., $l$-1

$$DoP_{dec} = \prod_{i=1}^{l-1} q^{(i)} \tag{8}$$

determines the maximum natural degree of parallelism (DoP) in the VSLI implementation of the decoder and, therefore, for a fixed clock frequency, its maximum throughput.

### Encoder architecture

For any throughput target, the encoder system 12 can be implemented with a lower DoP than the decoder because, differently from belief propagation, the encoding algorithm is not iterative. We choose the DoP of the encoder as the product of the upper $l - m$ $(0 < m < l)$ lifting stages:

$$DoP_{enc} = \prod_{i=m}^{l-1} q^{(i)} \leq DoP_{dec}. \tag{9}$$

The patent application WO2004/077733A2 entitled "Method and Apparatus for Performing Low-Density Parity-Check (LDPC) Code Operations using a Multi-Level Permutation" by Tom Richardson proposes a method to implement different degrees of parallelism, e.g. between encoder and decoder. Whereas the method of WO2004/07773A2 makes use of non-cyclic permutations that can be factorized in two permutation operations performed on equally sized vectors, our method relies on a hierarchical lifting, which induces a series of cyclic permutations with increasingly finer granularity.

The triangular structure of $H_2$, enforced by the code construction, results in the following simple encoding procedure. The $i$-th parity bit of the LDPC code (i = 0,1, ..., $n^{(l)} - k^{(l)} - 1$) is computed as the accumulated exclusive or (XOR) operation of the information bits and, for $i \neq 0$, the previous parity bits involved in the $i$-th row of the PCM $H$. At each step the encoder must keep track of the XOR-accumulated values. Therefore, the state of the encoder consists of one bit per each row of the PCM, i.e., in total $n^{(l)} - k^{(l)}$ bits that are updated via XOR accumulation.

We mention in passing that for non-binary LDPC codes the XOR accumulation of selected bits must be replaced by the multiplication of the variables by their corresponding coefficients and the subsequent accumulated addition in the respective Galois field.

The proposed architecture implements systematic encoding. During an "information phase", the information bits enter the encoder, are used to update the state accumulators, and are forwarded unmodified to the output. Subsequently, during a "parity phase", the accumulated XOR bits of each row are sent to the output as parity bits and fed back to the input of the encoder to update the XOR accumulators of the following rows.

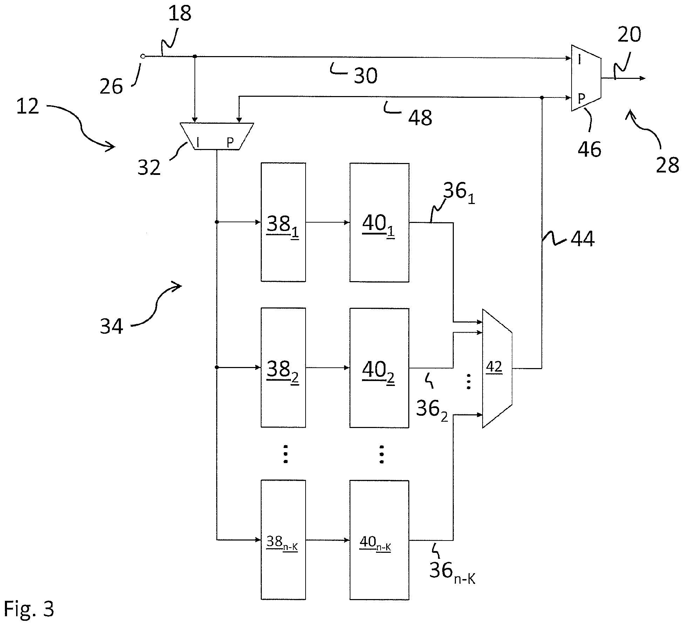

Fig. 3 schematically shows a block diagram of an exemplary systematic LDPC encoder system 12. Every connector in the diagram represents a bus of width $DoP_{enc}$.

The input information bits 18 to be encoded are received at an input node 26, and are forwarded towards an output node 28 via a bypass line 30. Moreover, the input bits 18 are copied and provided, via an input switch unit 32, to an encoding circuit 34 that is adapted to compute the parity bits for the LDPC.

As further illustrated in Fig. 3, the encoding circuit 34 comprises $n^{(1)} - k^{(1)}$ parallel encoding paths $36_1$ to $36_{n-k}$, each consisting of a respective permutator element $38_1$ to $38_{n-k}$ implemented in combinational logic, and an accumulator element $40_1$ to $40_{n-k}$ downstream of the respective permutator element $38_1$ to $38_{n-k}$. Here and in the description that follows, we use shorthand notation n-k for the subscripts $n^{(1)}$-$k^{(1)}$ etc., for ease of notation.

A row selector 42 selects among the encoding paths $36_1$ to $36_{n-k}$, and provides the respective parity bits 44 to a combiner switch 46 at the output node 28, where the parity bits 44 are combined with the input bits 18 to form the codeword bits 20.

As can be further taken from Fig. 3, the parity bits 44 from the encoding circuit 34 are additionally provided, via a feedback path 48, to the input switch unit 32, which selectively backfeeds them into the encoding circuit 32.

The two switches 32 and 46 in Fig. 3 are configured to route towards their output port the input of the I port during the information phase and the input of the P port during the parity phase.

The combinational permutator elements $38_1$ to $38_{n-k}$ implements the permutations associated with the lifting stages $m$, $m + 1$,..., $l - 1$, i.e., the upper $l - m$ lifting stages.

The connections of the input bits 18 with the XOR accumulator elements $40_1$ to $40_{n-k}$ as well as the connections of the XOR accumulator elements $40_1$ to $40_{n-k}$ with the output bits 20 depend on the cyclic permutation matrices chosen at each lifting stage for each entry of the protomatrices. In a VLSI implementation of a LDPC encoder system 12, routing generally represents the bottleneck that limits the achievable throughput. The connections between the input/output ports and the processing core are usually implemented via a dedicated permutation block, or "permutator" that dominates the silicon area and therefore the costs of the circuit. In the following we describe a simple permutation architecture for the considered code construction.

We will refer to the rows and columns of the protomatrix $H^{(i)}$ ($i = 1,2,...,l$) as $i$-rows and $i$-columns, respectively. During the lifting procedure, each $i$-row ($i$-column) expands to $q^{i,j}$ $j$-rows ($j$-columns) ($j \geq i$), respectively, where

$$q^{(i,j)} \triangleq \begin{cases} \prod_{r=i}^{j-1} q^{(r)} & (j > i) \\ 1 & (j = i) \end{cases}. \qquad (10)$$

In particular, each 1-row or 1-column expands to $q^{(1,l)} = q^{(1,m)} \cdot DoP_{enc}$ rows or columns of the PCM $H$, respectively. The $DoP_{enc}$ (information or parity) bits at the output of switch unit 32 correspond to an m-column, and each path corresponds to a 1-row.

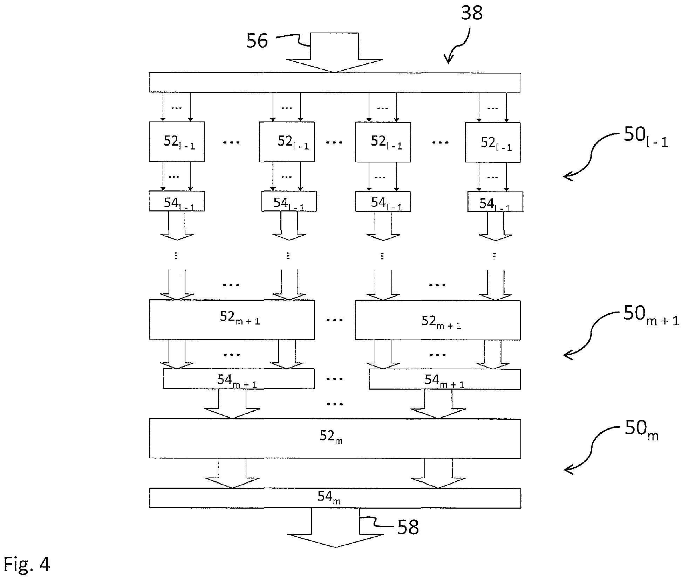

Each combinational permutator element 38, such as the combinational permutator elements $38_1$ to $38_{n-k}$, can be conveniently realized as a cascade of $l - m$ barrel shifter groups $50m - 50_{l-1}$, as illustrated in Fig. 4. Every $q^{(i)}$-level barrel shifter group $50_i$ ($i = m, m + 1, ..., l - 1$) comprises $q^{(i)}$ barrel shifter units $52_i$ and $q^{(i)}$ combiner units $54_i$, and operates on $q^{(i)}$ busses of $q^{(i+1,l)}$ bits each by applying a configurable circular permutation. The input bus 56 is initially split into $DoP_{enc}$ bits that are progressively recombined after each barrel shifter until, eventually, a single output bus 58 of $DoP_{enc}$ bits is obtained. Although the functionality of the whole combinational permutator 38 is purely combinational, pipeline stages can be inserted where required to achieve timing closure in the VLSI implementation without changing the principle of operation.

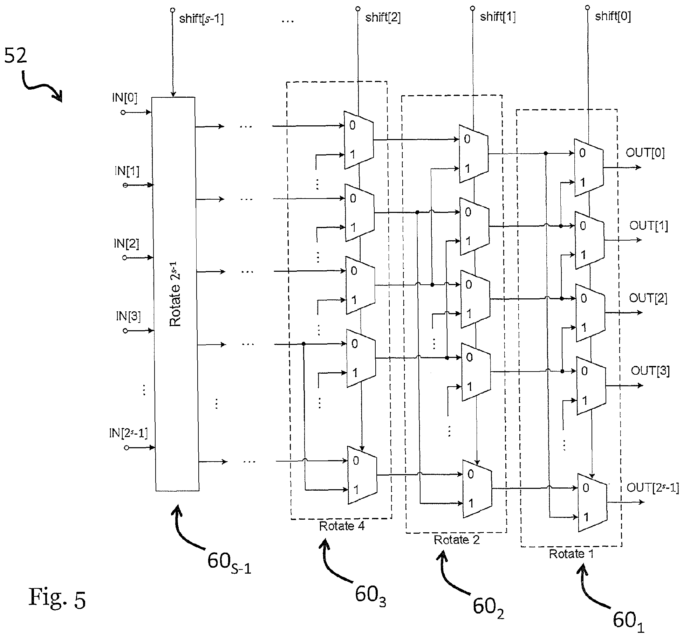

Barrel shifters are well-known building blocks of digital circuits. For the sake of completeness, the block diagram of a generic $2^s$-level barrel shifter (for a positive integer S) is shown in Fig. 5. The connectors represent busses of appropriate width. The circuit consists of multiple cascaded stages $60_i$: The $i$-th stage ($i = 0,1,..., s - 1$) can operate in bypass mode or can rotate cyclically the input signal by $2^i$ positions. For more details we refer to the tutorial paper "Design alternatives for barrel shifters," by M. R. Pillmeier et al. published in December 2002 in the SPIE Proceedings, vol. 4791.

Besides XOR accumulation, the accumulator elements $40_1$ to $40_{n-k}$ in Fig. 3 implement, by means of the addressing scheme, the permutations associated with the lifting stages 1, 2, ..., $m - 1$, i.e. the lower $m - 1$ lifting stages. The lifting stage 0, which is used to remove the parallel edges from the initial protograph, does not correspond to a permutation function and is implicitly implemented through the use of $n^{(1)} - k^{(1)}$ rather than $n^{(0)} - k^{(0)}$ parallel paths in the encoder.

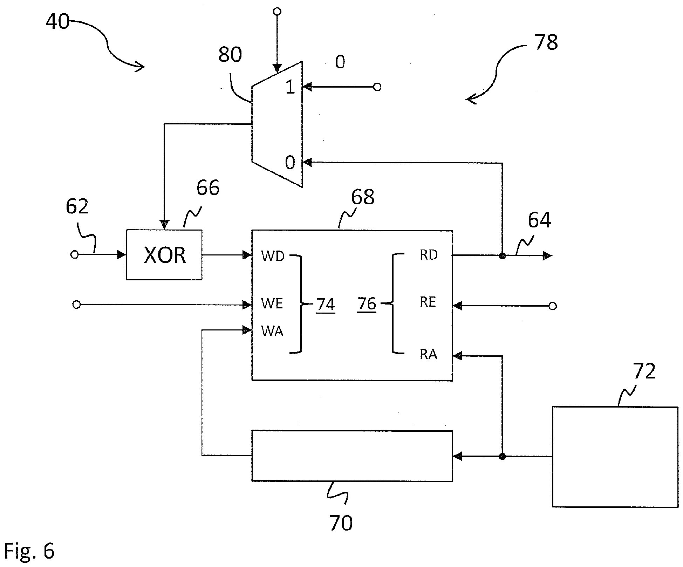

Fig. 6 illustrates an exemplary implementation of an accumulator element 40, such as one of the accumulator elements $40_1$ to $40_{n-k}$ in Fig. 3. The $i$-th accumulator $40_i$ ($i = 0, 1, ... , n^{(1)} - k^{(1)} - 1$) stores the $DoP_{enc} \cdot q^{(1,m)}$ state bits associated with the i-th 1-row. All accumulators together hence store $(n^{(1)} - k^{(1)} \cdot DoP_{enc} \cdot q^{(1,m)} = n^{(l)} - k^{(l)}$ state bits.

The accumulator element 40 comprises a data input node 62 adapted to receive input data, such as from the permutator element 38, and data output node 64. As can be taken from Fig. 6, the accumulator element 40 further comprises an XOR gate element 66, a memory element 68, a delay element 70, and an address generator element 72.

By recalling that each 1-row corresponds to $q^{(1,m)}$ $m$-rows and that each $m$-row is associated with $DoP_{enc}$ state bits, we organize the accumulator storage in $q^{(1,m)}$ words of $DoP_{enc}$ bits each, whereby each word corresponds to an m-row. It is now important to realize that

- the $DoP_{enc}$ bits transported at any given time by the input bus belong to the same m-column;
- due to the use of (circular) permutation matrices in the lifting procedure, each m-column intersects at most one of the $q^{(1,m)}$ $m$-rows associated with a given 1-row.

This implies that, at any given time, at most one of the stored words must be updated.

This fact allows us to implement the storage via a memory element 68 with a single read-port 74 and a single write-port 76 without access conflicts, such as a standard two-port random-access memory (RAM). Both the write port 74 and the read port 76 may have separated data (WD and RD), address (WA and RA) and enable (WE and RE) signals. At any given time the $i$-th accumulator $40_i$ (for each $i = 0,1,..., n^{(1)} - k^{(1)} - 1$) reads, updates and writes at most a single set of $DoP_{enc}$ state bits, corresponding to one of the $q^{(1,m)}$ m-rows associated with the $i$-th 1-row.

The index of the intersecting m-row (between 0 and $q^{(1,m)}$ 1) depends on the circular permutation matrices chosen at the lower $m - 1$ lifting stages. By recalling that a $q^{(i)} \times q^{(i)}$ circulant matrix is univocally specified by a shifting factor in $\{0,1, ..., q^{(i)} - 1\}$, we can establish a natural indexing of the $m$-rows. To this end we sort the $q^{(1,m)}$ $m$-rows associated with the $i$-th 1-row in lexicographic order according to the shift factors used at the lifting stages $m - 1$, $m - 2$,..., 1. Of course, different indexing can be alternatively used.

The architecture and operation of the accumulator element will now be described in greater detail with further reference to Fig. 6.

A first input node of the XOR gate element 66 is connected to the input node 62, and, depending on the switch setting of the input switch 32, receives the permuted information bits (in the information phase) or parity bits (in the parity phase) from the permutator element 38. A second input of the XOR gate element 66 is connected, via an accumulator feedback path 78, to the read data (RD) output port of the memory element 68. The feedback path 78 comprises a reset switch unit 80 adapted to reset the accumulator 40 at the start of each new code word. The XOR gate element 66 computes the "exclusive or" of the signals received from the input node 62 and via the accumulator feedback path 78, and provides the result to the write data (WD) input port of the memory element 68.

The delay element 70, which accounts for the latency of the RAM, is connected to the read address (RA) output port of the memory element 68 and the write address (WA) input of the memory element, and may be employed to derive the write address from the read address. The addressing scheme within the accumulator 40 implements the functionality of the lower $m-1$ stages of the permutation. The address generator 72 is connected to the memory element 68 and the delay element 70, and may consist of a linear counter and a look-up table (not shown in Fig. 6). The linear count may be remapped to the actual RAM addresses contained in the look-up table and generated from the circular shift factors of the permutation matrices according to the chosen indexing.

Due to the sparse nature of the $H^{(1)}$ protomatrix, a 1-column does not necessarily intersect each 1-row. Accordingly, it is possible that the processed $m$-column does not intersect any of the $q^{(1,m)}$ $m$-rows associated with the $i$-th accumulator ($i = 0,1, ..., n^{(1)} - k^{(1)} - 1$). In this case the write enable of the memory element 68 can be used to prevent updating the accumulator state. A clock gating technique can be used to disable the accumulators 40 during the idle periods and save power consumption.

The row selector 42 in Fig. 3 is used during the parity phase to route the content of the XOR accumulators $40_1$

to $40_{n-k}$ to the output, where it provides the parity bits 44. We recall that in the code construction, we used at the $i$-th stage ($i$ = 0, 1, ..., $l$-1) zero-shift permutation matrices (i.e. identity matrices) for the diagonal elements of $H_2^{(i)}$. As a consequence, the accumulated bits are read in the natural ("unpermutated") order, i.e., the $r$-th parity bit ($r$ = 0,1,..., $n^{(l)} - k^{(l)}$ - 1) coincides with the content of the XOR accumulator $40_r$ associated with the $r$-th row of the PCM $H$. Further, since not only the final matrix $H_2$, but also each intermediate matrix and, in particular, $H_2^{(m)}$ is triangular, the $DoP_{enc}$ parity bits belonging to the same $m$-column are mutually independent. This circumstance allows us to compute $DoP_{enc}$ parity bits simultaneously rather than sequentially and enables the desired degree of parallelism.

The encoding system 12 of Fig. 3 can be easily adapted to encode in time sharing L block-interleaved LDPC codewords, whereby at any time slot $i$ the code word ($i$ mod $L$) is processed. To this end it is sufficient to expand the storage in each accumulator RAM to $L \cdot q^{(1,m)}$ words of $DoP_{enc}$ bits each. Accordingly, the RAM address depends not only on the circular permutation matrices chosen at the lower $m$ - 1 lifting stages but also on the code word index ($i$ mod $L$). We mention that the time sharing approach besides improving the burst error tolerance of the forward error correction (FEC) scheme, increases the number of allowable latency cycles in the feedback loops 48, 78 in Figs. 3 and 6 and, thus, simplifies the VLSI implementation.

In the examples described above with reference to Figs. 3 to 6, the lifting procedure has been constrained by requiring zero-shift permutation matrices, i.e. identity matrices, for the diagonal elements. This constraint leads to a particularly efficient implementation and architecture of the encoder structure, but is not an essential constraint. If the constraint is dropped, the encoding method may proceed similarly. For instance, an additional permutator element may be added downstream of the row selector 42 in the encoder architecture of Fig. 3.

The description of the embodiments and the drawings merely serve to illustrate the method and system according to the invention, but should not be understood to imply any limitation. The scope of the invention is to be determined from the appended claims.

<u>Reference Signs</u>

| | |
|---|---|
| 10 | data transmission system |
| 12 | encoding system |
| 14 | transmission channel |
| 16 | decoding system |
| 18 | input symbols |
| 20 | code symbols |
| 22 | transmitted code symbols |
| 24 | decoded code symbols |
| 26 | input node |
| 28 | output node |
| 30 | bypass line |
| 32 | input switch |
| 34 | encoding circuit |
| $36_1$ - $36_{n-k}$ | encoding paths |
| 38 | permutator element |
| $38_1$ - $38_{n-k}$ | permutator elements of encoding paths $36_1$ to $36_{n-k}$ |
| 40 | accumulator element |
| $40_1$ - $40_{n-k}$ | accumulator elements of encoding paths $36_1$ to $36_{n-k}$ |
| 42 | row selector |
| 44 | parity bits |
| 46 | combiner switch |
| 48 | feedback path |
| 50m - $50_{l-1}$ | barrel shifter groups |
| 52 | barrel shifter |
| 52m - $52_{l-1}$ | barrel shifter units |
| 54m - $54_{l-1}$ | combiner units |
| 56 | input bus of permutator element 38 |

| 58 | output bus of permutator element 38 |
| 60$_i$ | stages of barrel shifter 52 |
| 62 | data input node of accumulator element 40 |
| 64 | data output node of accumulator element 40 |
| 66 | XOR gate element of accumulator element 40 |
| 68 | memory element of accumulator element 40 |
| 70 | delay element of accumulator element 40 |
| 72 | address generator element of accumulator element 40 |
| 74 | input port and related control ports of memory element 68 |
| 76 | output port and related control ports of memory element 68 |
| 78 | feedback path of accumulator element 40 |
| 80 | reset switch unit |

**Claims**

1. An encoding method for a parity check code, wherein the encoding is based on a *(n - k) x n* parity check matrix, wherein n denotes a block length of a code word and *k* denotes a block length of an input word, and wherein the parity check matrix H can be represented in the form

$$H = [\, H_1, H_2\,],$$

wherein H$_1$ is a *(n-k) x k* matrix, and H$_2$ is a triangular *(n-k) x (n-k)* matrix;
the encoding method comprising:

generating the parity check matrix (H) by means of iterative lifting of smaller parity check matrices.

2. The encoding method according to claim 1, wherein the encoding has a degree of parallelism that corresponds to a product of a plurality of lifting factors, in particular a product of a subset of the lifting factors.

3. The encoding method according to any of the preceding claims, wherein the encoding comprises a parallel processing of a plurality of rows of the parity check matrix (H), in particular a parallel processing of all rows of the parity check matrix (H).

4. The encoding method according to any of the preceding claims, wherein the encoding comprises applying a first plurality of permutations to an input symbol (18), the first plurality of permutations pertaining to a first plurality of lifting stages, in particular a first plurality of lifting stages consisting of all lifting stages including and beyond the m-th lifting stage, for an integer m $\geq$ 2.

5. The encoding method according to claim 4, wherein the first plurality of permutations are applied by means of a combinational logic circuit.

6. The encoding method according to any of the preceding claims, wherein the encoding comprises an accumulated addition operation, in particular after a step of permuting a plurality of input symbols.

7. The encoding method according to claim 6, wherein the accumulated addition operation comprises a second plurality of permutations pertaining to a second plurality of lifting stages, in particular a second plurality of lifting stages consisting of all lifting stages below the m-th lifting stage, for an integer m $\geq$ 2.

8. The encoding method according to claim 6 or 7, wherein the second plurality of lifting stages are applied by means of a memory element, in particular a RAM element.

9. The encoding method according to any of the preceding claims, wherein the encoding comprises computing a second plurality of parity check symbols pertaining to a second input block as an accumulated addition operation of a plurality of information symbols pertaining to the second input block and a first plurality of parity check symbols pertaining to a first input block, wherein the first input block in particular precedes the second input block.

**10.** The encoding method according to any of the preceding claims, wherein the encoding comprises backfeeding parity check symbols (44) from an output of an encoding circuit (34) to an input of the encoding circuit (34).

**11.** An encoding system (12), comprising:

an input node (26) for receiving information symbols (18);
an encoding circuit (34) connected to the input node (26), and comprising:

a plurality of permutator elements (38; $38_1$ - $38_{n-k}$) associated with a plurality of encoding paths ($36_1$ - $36_{n-k}$); and
a plurality of accumulator elements (40; $40_1$ - $40_{n-k}$) associated with the plurality of encoding paths ($36_1$-$36_{n-k}$);

a feedback path (48) adapted to backfeed output symbols of the encoding circuit (34) to an input of the encoding circuit (34); and
an output node (28) connected to the encoding circuit (34), wherein the output node (28) is adapted to output codeword symbols (20).

**12.** The encoding system (12) according to claim 11, further comprising a bypass path (30) adapted to provide the information symbols (18) from the input node (26) to the output node (28).

**13.** The encoding system (12) according to claim 11 or 12, wherein the permutator elements (38; 381 - $38_{n-k}$) are adapted to apply a first plurality of permutations pertaining to a first plurality of lifting stages, in particular a first plurality of lifting stages consisting of all lifting stages including and beyond the m-th lifting stage, for an integer m $\geq$ 2.

**14.** The encoding system (12) according to any of the claims 11 to 13, wherein the accumulator elements (40; $40_1$ - $40_{n-k}$) are adapted to compute a second plurality of parity symbols pertaining to a second input block of information symbols as an accumulated addition operation of a plurality of information symbols pertaining to the second input block provided from the input note, and a first plurality of parity symbols pertaining to a first input block of information symbols, wherein the first plurality of parity symbols are provided via the feedback path (48).

**15.** The encoding system (12) according to any of the claims 11 to 14, wherein the plurality of accumulator elements (40; $40_1$ - $40_{n-k}$) comprise a memory with a single read port and a single write port.

10

18    12            20    14            22    16            24

→      | E |      →      | T |      →      | D |      →

Fig. 1

Fig. 2

Fig. 3

Fig. 4

Fig. 5

EP 3 496 277 A1

Fig. 6

Europäisches
Patentamt

European
Patent Office

Office européen
des brevets

## EUROPEAN SEARCH REPORT

Application Number

EP 17 20 5983

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | EP 3 002 880 A1 (BROADCOM CORP [US])<br>6 April 2016 (2016-04-06)<br>* figures 4B,4C, 5A-C,6A-C,8B *<br>* paragraph [0089] - paragraph [0123] * | 1-3,6,9,<br>10<br>4,5,7,8 | INV.<br>H03M13/11 |
| X | AHMED MAHDI ET AL: "An encoding scheme and encoder architecture for rate-compatible QC-LDPC codes",<br>PROC., IEEE WORKSHOP ON SIGNAL PROCESSING SYSTEMS, SIPS 2011,,<br>4 October 2011 (2011-10-04), pages 328-333, XP032029173,<br>DOI: 10.1109/SIPS.2011.6088997<br>ISBN: 978-1-4577-1920-2<br>* the whole document * | 11-15 | |
| X<br><br><br><br><br><br>A | FEWER C P ET AL: "A Versatile Variable Rate LDPC Codec Architecture",<br>IEEE TRANSACTIONS ON CIRCUITS AND SYSTEMS I: REGULAR PAPERS, IEEE, US,<br>vol. 54, no. 10,<br>1 October 2007 (2007-10-01), pages 2240-2251, XP011194107,<br>ISSN: 1549-8328, DOI:<br>10.1109/TCSI.2007.904641<br>* III. Versatile Encoder Architecture;<br>page 2242 - page 2244; figure 4 * | 11,12,<br>14,15<br><br><br><br><br><br>13 | TECHNICAL FIELDS SEARCHED (IPC)<br><br>H03M |
| A | US 2006/291571 A1 (DIVSALAR DARIUSH [US] ET AL) 28 December 2006 (2006-12-28)<br>* paragraph [0040] - paragraph [0055];<br>figures 1,4,5,6 * | 1-15 | |

-/--

The present search report has been drawn up for all claims

| Place of search | Date of completion of the search | Examiner |
|---|---|---|
| Munich | 1 August 2018 | Offer, Elke |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
................................................................
& : member of the same patent family, corresponding
    document

EPO FORM 1503 03.82 (P04C01)

page 1 of 3

# EP 3 496 277 A1

**Europäisches Patentamt**
**European Patent Office**
**Office européen des brevets**

## EUROPEAN SEARCH REPORT

Application Number

EP 17 20 5983

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JINGLI LIN ET AL: "Efficient encoding of low-density parity-check codes in chinese digital terrestrial television broadcasting standard", PROC., IEEE 5TH INTERNATIONAL CONFERENCE ON COMMUNICATIONS, CIRCUITS AND SYSTEMS, KOKURA, JAPAN, 11 July 2007 (2007-07-11), - 13 July 2007 (2007-07-13), pages 14-18, XP032219178, DOI: 10.1109/ICCCAS.2007.6247586 ISBN: 978-1-4244-1473-4 * the whole document * | 1-15 | |
| A | YONGMIN JUNG ET AL: "7.7Gbps encoder design for IEEE 802.11n/ac QC-LDPC codes", PROC., IEEE INTERNATIONAL SOC DESIGN CONFERENCE, ISOCC 2012, 4 November 2012 (2012-11-04), pages 215-218, XP032301900, DOI: 10.1109/ISOCC.2012.6407078 ISBN: 978-1-4673-2989-7 * the whole document * | 1-15 | |
| A,D | MAHDI AHMED ET AL: "A Low Complexity-High Throughput QC-LDPC Encoder", IEEE TRANSACTIONS ON SIGNAL PROCESSING, IEEE SERVICE CENTER, NEW YORK, NY, US, vol. 62, no. 10, 1 May 2014 (2014-05-01), pages 2696-2708, XP011546461, ISSN: 1053-587X, DOI: 10.1109/TSP.2014.2314435 [retrieved on 2014-04-25] * the whole document * | 1-15 | TECHNICAL FIELDS SEARCHED (IPC) |

-/--

The present search report has been drawn up for all claims

| Place of search | Date of completion of the search | Examiner |
|---|---|---|
| Munich | 1 August 2018 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | N. MILADINOVIC; M. FOSSORIER: "Systematic recursive construction of LDPC codes", IEEE COMMUNICATIONS LETTERS, vol. 8, no. 5, 2004, pages 302-304, XP001198354, * the whole document * | 1-15 | |

-----

TECHNICAL FIELDS
SEARCHED      (IPC)

The present search report has been drawn up for all claims

| Place of search | Date of completion of the search | Examiner |
|---|---|---|
| Munich | 1 August 2018 | Offer, Elke |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 17 20 5983

The Search Division considers that the present European patent application does not comply with the requirements of unity of invention and relates to several inventions or groups of inventions, namely:

1. claims: 1-10

   Encoding method for a parity check code based on a parity check matrix comprising a triangular matrix wherein the encoding method comprises generating the parity check matrix by means of iterative lifting of smaller parity check matrices.

   ---

2. claims: 11-15

   Encoding system comprising an encoding circuit comprising a plurality of permutator elements associated to encoding paths, a plurality of accumulator elements associated with the encoding paths, a feedback path and an output node.

   ---

**EP 3 496 277 A1**

## ANNEX TO THE EUROPEAN SEARCH REPORT
## ON EUROPEAN PATENT APPLICATION NO.

EP 17 20 5983

This annex lists the patent family members relating to the patent documents cited in the above-mentioned European search report.
The members are as contained in the European Patent Office EDP file on
The European Patent Office is in no way liable for these particulars which are merely given for the purpose of information.

01-08-2018

| Patent document cited in search report | | Publication date | Patent family member(s) | | Publication date |
|---|---|---|---|---|---|
| EP 3002880 | A1 | 06-04-2016 | EP 3002880 A1<br>US 2016094246 A1 | | 06-04-2016<br>31-03-2016 |
| US 2006291571 | A1 | 28-12-2006 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004077733 A2
- WO 200407773 A2

**Non-patent literature cited in the description**

- **T. J. RICHARDSON ; R. L. URBANKE.** Efficient encoding of low-density parity-check codes. *IEEE Transactions on Information Theory,* 2001, vol. 47 (2), 638-656
- **A. MAHDI ; V. PALIOURAS.** A low complexity-high throughput QC-LDPC encoder. *IEEE Transactions on Signal Processing,* 2014, vol. 62 (10), 2696-2708
- **N. MILADINOVIC ; M. FOSSORIER.** Systematic recursive construction of LDPC codes. *IEEE Communications Letters,* 2004, vol. 8 (5), 302-304
- **M. R. PILLMEIER et al.** Design alternatives for barrel shifters. *SPIE Proceedings,* December 2002, vol. 4791